# EUROPÄISCHE PATENTSCHRIFT

(11) **EP 2 580 950 B1**
(45) Veröffentlichungstag und Bekanntmachung des Hinweises auf die Patenterteilung: **10.09.2014**
(21) Anmeldenummer: 11729887.7
(22) Anmeldetag: 31.05.2011
(51) Int. Cl.: H05K 7/14

(54) **WECHSELRICHTER**
INVERTER
ONDULEUR

(30) Priorität: 08.06.2010 AT 9352010
(43) Veröffentlichungstag der Anmeldung: 17.04.2013
(73) Patentinhaber: Fronius International GmbH, 4643 Pettenbach (AT)
(72) Erfinder: DORFER, Wolfgang, A-4053 Neuhofen/Krems (AT); WIESINGER, Manfred, A-4645 Bad Wimsbach Neydharting (AT); STEMPFL, Sebastian, 5280 Braunau / Inn (AT); HUEMER, Bernhard, A-4553 Schlierbach (AT)
(74) Vertreter: Sonn & Partner Patentanwälte
(86) Internationale Anmeldenummer: PCT/AT2011/000248
(87) Internationale Veröffentlichungsnummer: WO 2011/153564

(56) Entgegenhaltungen:
- EP-A1- 2 006 988
- EP-A2- 0 356 991
- WO-A1-98/36462
- US-A- 5 007 859

## Beschreibung

Die Erfindung betrifft einen Wechselrichter, mit einem oberen und unterem Gehäuseteil, wobei im oberen und unteren Gehäuseteil elektronische Komponenten angeordnet sind, die über ein aus zwei Teilen gebildetes Kontaktierungssystem lösbar miteinander elektrisch verbunden sind.

Ein solcher Wechselrichter ist aus EP-A2-0 356 991 bekannt.

Üblicherweise sind Wechselrichter derart ausgebildet, dass ein unterer Geräteteil oder eine Halterung (Wandhalterung, Ständer, usw.) oder das komplette Gerät montiert wird und anschließend der Gehäuseoberteil auf diesen Unterteil geschraubt oder gesteckt wird.

Die Aufgabe der Erfindung liegt darin, einen Wechselrichter zu schaffen, bei dem eine elektrische und mechanische Verbindung zweier Geräteteile und/oder Gehäuseteile oder Geräte über eine Schwenkbewegung ermöglicht wird.

Gelöst wird die Aufgabe der Erfindung dadurch, dass der obere Gehäuseteil über ein Drehelement mit dem untere Gehäuseteil manuell abnehmbar verbunden ist, wobei das Drehelement eine Drehachse für einen Kreisbogen bildet, und dass im oberen und unteren Gehäuseteil jeweils ein Teil des Kontaktierungssystems derart entlang des Kreisbogens angeordnet ist, dass diese während einer Schwenkbewegung des oberen Gehäuseteils gegenüber dem unteren Gehäuseteil in eine Betriebsstellung bei verbundenen Gehäuseteilen automatisch kontaktierbar sind. Vorteilhaft ist hierbei; dass mit Hilfe der neu entwickelten Komponenten die komplette Baugruppe somit Anschluss-, Schalt- und Trennfunktionen erfüllt. Bei entsprechender Zusatzbeschaltung kann diese Baugruppe auch die Schalt- und Trennfunktionen erfüllen. Ein weiterer Vorteil liegt darin, dass der Installateur oder Benutzer die Halterung, also den unteren Gehäuseteil, vormontieren und anschließen kann. Dadurch wird erreicht, dass nur ein kleines oder geringes Gewicht bei der Montage entsteht, da viele Komponenten im oberen Gehäuseteil, welcher für die Montage abgenommen wird, angeordnet und befestigt sind. Damit ist auch eine sehr gute Zugänglichkeit zu den Anschlussklemmen gegeben, da störende Komponenten im weiteren Gehäuseteil angeordnet sind. Im Servicefall verbleibt die Halterung oder der untere Gehäuseteil inklusive der angeschlossenen elektrischen Leitungen vor Ort, und das Gerät kann auch schnell ausgetauscht werden. Auch wird dadurch eine Handhabung mit spannungsführenden Leitungen im Servicefall vermieden. Durch die spezielle Ausführung des Kontaktierungssystems und des Drehelements wird eine "fließende" Kontaktierung erzielt und ein Verklemmen der Teile untereinander verhindert.

Vorteilhafterweise weist der obere Gehäuseteil eine Kulissenbahn zur Aufnahme des Drehelements auf, wodurch in einfacher Weise durch einfaches Aufstecken auf das Drehelement der Gehäuseteil gehalten und positioniert wird.

Wenn die Kulissenbahn über eine definierte Länge in einem Durchmesser des Drehelements in Längsrichtung des Gehäuses verläuft, worauf sich die Kulissenbahn winkelig nach außen erstreckt und somit eine Öffnung zur Aufnahme des Drehelements am oberen Gehäuseteil ausgebildet ist, kann eine einfache Führung für die Positionierung der beiden Gehäuseteile zueinander erreicht werden.

Beim Kontaktierungssystem ist vorteilhafterweise in einem Gehäuseteil oder Gerät zumindest ein Einzelelement mit einem Federkontakt und korrespondierend dazu im weiteren Gehäuseteil oder Gerät zumindest eine Kontaktfahne des Kontaktierungssystems angeordnet. Dadurch kann gleichzeitig mit der mechanischen Befestigung eine elektrische Verbindung hergestellt werden.

Gemäß einer Ausbildung ist an einer Seite eines Gehäuses des Einzelelements des Kontaktierungssystems ein Kontaktelement und an einer anderen Seite des Gehäuses ein Anschlusselement für eine Leitung, eine Leiterplatte oder Kabel angeordnet, und das Kontaktelement und das Anschlusselement elektrisch miteinander verbunden. Dadurch kann ein neu entwickelter Schwenkkontakt in dem unteren Gehäuse montiert werden. Diese Kontaktkombination kann den Drehwinkel des Schwenkrahmens aufnehmen, sodass beispielsweise eine auf einer Leiterplatte montierte Kontaktfahne über einen Kreisbogen eingeführt werden kann.

Von Vorteil ist aber auch eine Ausbildung, bei der das Kontaktelement an einer dem Anschlusselement gegenüberliegenden Seite, also einer Stirnseite des Gehäuses, offen oder frei zugänglich ausgebildet ist. Dadurch ist das Einführen der Kontaktfahne auch über einen Teilbereich der Stirnfläche, wie dies bei einer Kurvenbahn notwendig ist, in das Kontaktelement möglich. Somit wird sichergestellt, dass die Kontakte beim Anheben des oberen Gehäuseteils getrennt werden und somit die elektronischen Komponenten des unteren Gehäuseteils von den elektronischen Komponenten des oberen Gehäuseteils mit dieser Bewegung getrennt werden, jedoch noch eine mechanische Verbindung der Gehäuseteile bestehen bleibt. Das Betätigen der Schalt- und Trennfunktion kann manuell zum Beispiel durch Ziehen oder Drücken oder mittels Schwenkhebel direkt oder mechanisch vorgespannt (zum Beispiel federnd) erfolgen. Auch ist eine Kombination aus beiden Betätigungen möglich.

Bevorzugt ist das Kontaktelement durch zumindest einen, insbesondere zwei Federkontakt(e) gebildet, wobei im Gehäuse eine bevorzugt rechteckförmige Ausnehmung, insbesondere ein Schlitz, zur Anordnung des zumindest einen Federkontakts angeordnet ist.

Schließlich ist es von Vorteil, wenn die Federkontakte stehend, also in einem Winkel von im Wesentlichen 90° zu einer Auflagefläche im Gehäuse angeordnet sind, sodass die Kontaktfahne von oben in einer kreisförmigen Bahn in das Kontaktelement einsteckbar ist.

Die vorliegende Erfindung wird anhand der beiliegenden Zeichnungen näher erläutert. Darin zeigen:
Fig. 1 ein schematisches Blockschaltbild eines Wechselrichters mit daran angeschlossenen Komponenten;
Fig. 2 eine teilweise geschnittene, schematische Darstellung eines Wechselrichters in der Betriebsstellung mit geschlossenem Gehäuse;
Fig. 3 eine teilweise geschnittene, schematische Darstellung eines Wechselrichters in geöffneter Stellung, also mit getrenntem oberen und unteren Gehäuseteil; und
Fig. 4 bis 8 verschiedene Ansichten eines Kontaktierungssystems, insbesondere eines Einzelelements für den Wechselrichter, in vereinfachter, schematischer Darstellung.

Einführend sei festgehalten, dass in dem dargestellten Ausführungsbeispiel gleiche Teile mit gleichen Bezugszeichen versehen werden, wobei die in der gesamten Beschreibung enthaltenen Offenbarungen sinngemäß auf gleiche Teile mit gleichen Bezugszeichen übertragen werden können. Auch sind die in der Beschreibung gewählten Lageangaben, wie z.B. oben, unten, seitlich, usw. auf die unmittelbar beschriebene sowie dargestellte Figur bezogen und sind bei einer Lageänderung sinngemäß auf die neue Lage zu übertragen. Weiters können auch Einzelmerkmale oder Merkmalskombinationen aus den gezeigten und beschriebenen Ausführungsbeispielen für sich eigenständige, erfinderische oder erfindungsgemäße Lösungen darstellen.

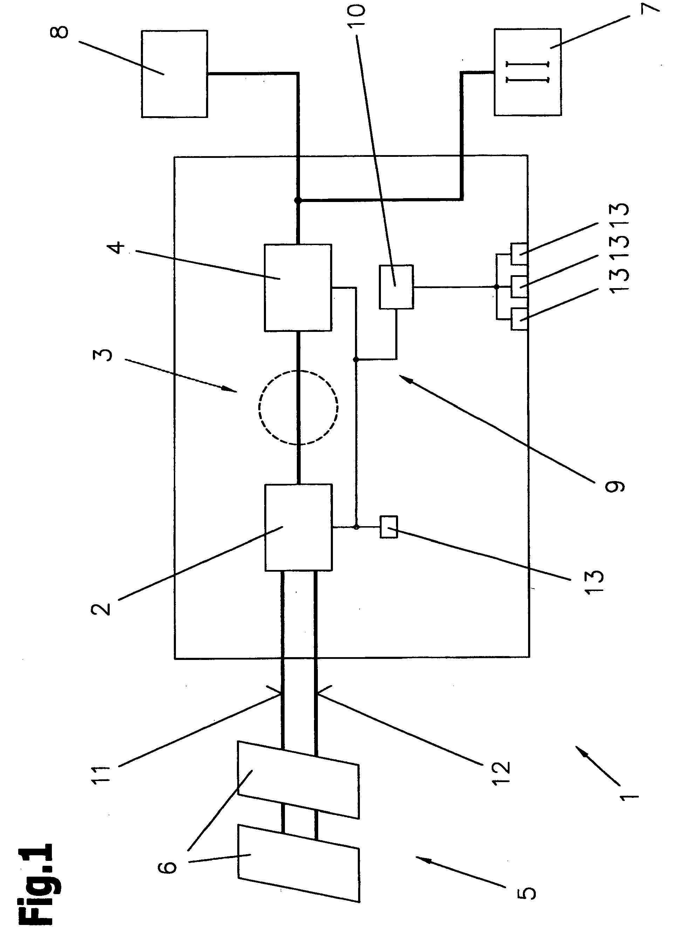

In Fig. 1 ist ein Aufbau eines bekannten Wechselrichters 1, im Detail eines HF-Wechselrichters, dargestellt. Da die einzelnen Komponenten bzw. Baugruppen und Funktionen von Wechselrichtern 1 bereits aus dem Stand der Technik bekannt sind, wird auf diese nachstehend nicht im Detail eingegangen.

Der Wechselrichter 1 weist zumindest einen Eingangs-DC-DC-Wandler 2, einen Zwischenkreis 3 und einen Ausgangs-DC-AC-Wandler 4 auf. Am Eingangs-DC-DC-Wandler 2 ist eine Energiequelle 5 angeschlossen, welche bevorzugt aus einem oder mehreren parallel und/oder seriell zueinander geschalteten Solarmodulen 6 gebildet wird. Der Wechselrichter 1 und die Solarmodule 6 werden auch als Photovoltaikanlage bzw. PV-Anlage bezeichnet. Der Ausgang des Wechselrichters 1 bzw. des Ausgangs-DC-AC-Wandlers 4 kann mit einem Versorgungsnetz 7, wie einem öffentlichen oder privaten Wechselspannungsnetz oder einem Mehr-Phasennetz, und/oder mit zumindest einem elektrischen Verbraucher 8, welcher eine Last darstellt, verbunden sein. Beispielsweise kann ein Verbraucher 8 durch einen Motor, einen Kühlschrank, ein Funkgerät usw. gebildet sein oder auch eine Hausversorgung darstellen. Die einzelnen Komponenten des Wechselrichters 1, wie der Eingangs-DC-DC-Wandler 2 usw., können über einen-Datenbus 9 mit einer Steuervorrichtung 10 verbunden sein.

Bevorzugt dient ein derartiger Wechselrichter 1 als sogenannter netzgekoppelter Wechselrichter 1, dessen Energiemanagement daraufhin optimiert ist, möglichst viel Energie in das Versorgungsnetz 7 einzuspeisen. Wie aus dem Stand der Technik bekannt, werden die Verbraucher 8 über das Versorgungsnetz 7 versorgt. Selbstverständlich können auch mehrere parallel geschaltete Wechselrichter 1 eingesetzt werden, wodurch mehr Energie zum Betrieb der Verbraucher 8 bereitgestellt werden kann. Diese Energie wird von der Energiequelle 5 in Form einer Gleichspannung geliefert, welche über zwei Anschlussleitungen 11, 12 mit dem Wechselrichter 1 verbunden ist.

Die Steuervorrichtung 10 bzw. der Regler des Wechselrichters 1 ist beispielsweise durch einen Mikroprozessor, Mikrocontroller oder Rechner gebildet. Über die Steuervorrichtung 10 kann eine entsprechende Steuerung der einzelnen Komponenten des Wechselrichters 1, wie des Eingangs-DC-DC-Wandlers 2 oder des Ausgangs-DC-AC-Wandlers 4, insbesondere der darin angeordneten Schaltelemente, vorgenommen werden. In der Steuervorrichtung 10 sind hierzu die einzelnen Regel- bzw. Steuerabläufe durch entsprechende Software-Programme und/oder Daten bzw. Kennlinien gespeichert.

Des Weiteren sind mit der Steuervorrichtung 10 Bedienelemente 13 verbunden, durch welche der Benutzer beispielsweise den Wechselrichter 1 konfigurieren und/oder Betriebszustände oder Parameter anzeigen - beispielsweise mittels Leuchtdioden - und einstellen kann. Die Bedienelemente sind dabei beispielsweise über den Datenbus 9 oder direkt mit der Steuervorrichtung 10 verbunden. Derartige Bedienelemente 13 können an einer Front des Wechselrichters 1 angeordnet sein, sodass eine Bedienung von außen möglich ist. Ebenso können die Bedienelemente 13 auch direkt an Baugruppen und/oder Modulen innerhalb des Wechselrichters 1 angeordnet sein.

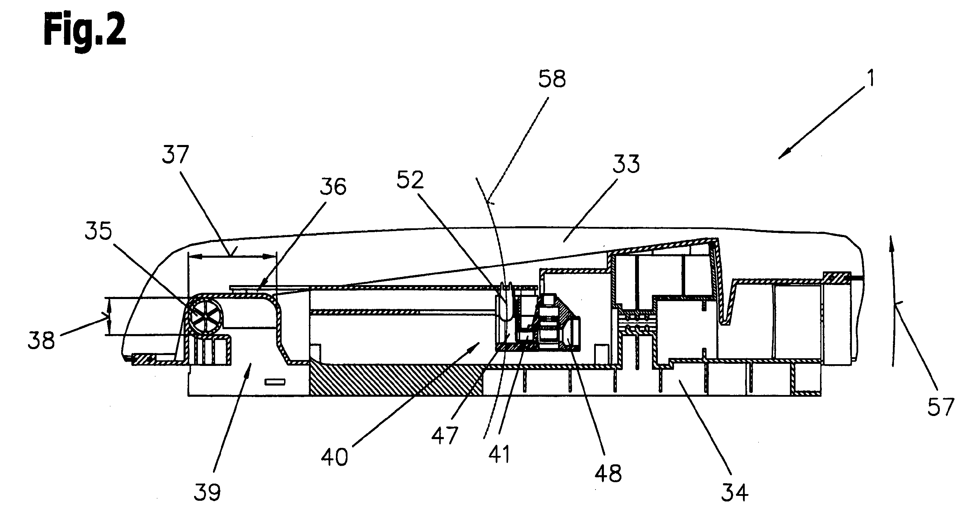

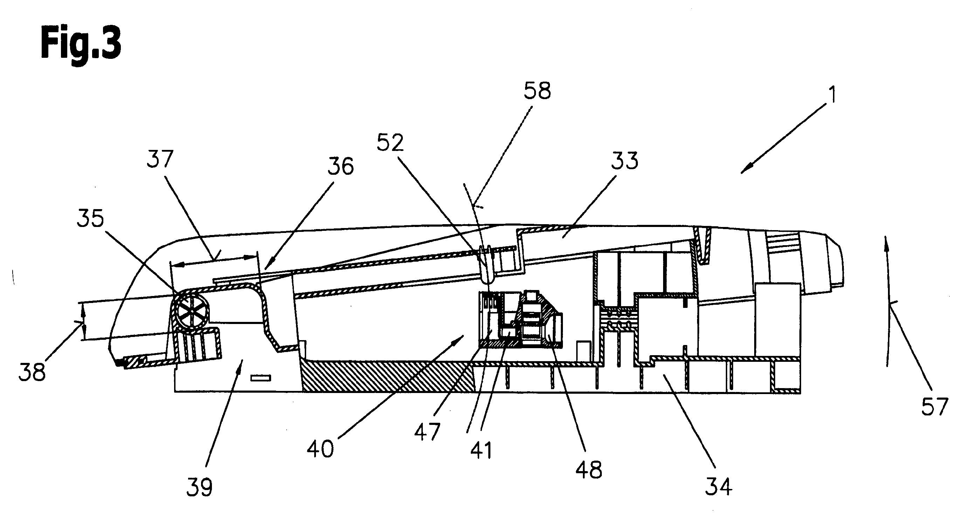

In den Fig. 2 und 3 ist ein Wechselrichter 1 in teilweise geschnittener, schematischer und vereinfachter Ansicht dargestellt. Der Wechselrichter weist einen oberen Gehäuseteil 33 und einen unteren Gehäuseteil 34 auf, deren Form beliebig ausgebildet sein kann und nicht auf das dargestellte Ausführungsbeispiel beschränkt ist. Bevorzugt sind zumindest die Bedienelemente 13 im oberen Gehäuseteil 33 integriert, die mit Signalen, Daten und Energie versorgt werden müssen.

Im geschlossenen oder montierten Zustand, also der Betriebstellung gemäß Fig. 2, sind der obere und untere Gehäuseteil 33, 34 miteinander verbunden und derart ausgebildet, dass diese mit ihren Vorsprüngen, Kanten usw. ineinander greifen und je nach Geräteausführung (IP-Klasse) entsprechend wasser- und staubdicht abschließen. Der obere Gehäuseteil 33 ist über ein Drehelement 35 am unteren Gehäuseteil 34 eingehängt oder gelagert. Dementsprechend ist das Drehelement 35 im unteren Gehäuseteil 34 angeordnet. Zum Einhängen weist der obere Gehäuseteil 33 eine Kulissenbahn 36 auf, d.h. der obere Gehäuseteil 33 ist im Bereich des Drehelements 35 derart geformt, dass die Kulissenbahn 36 über eine definierte Länge 37 entsprechend einem Durchmesser 38 des Drehelements 35 in Längsrichtung des Gehäuses verläuft und sich die Kulissenbahn 36 danach winkelig nach außen erstreckt und somit eine Öffnung 39 zur Aufnahme des Drehelements 35 am oberen Gehäuseteil 33 bildet. Durch die Kulissenbahn 36 wird eine Führung und Halterung für das Drehelement 35 am unteren Gehäuseteil 34 gebildet. Weiters kann auf der gegenüberliegenden Seite des Drehelements 35 und/oder der Kulissenbahn 36 ein Befestigungsmittel (nicht dargestellt) zum Verschließen der beiden Gehäuseteile 33, 34 angeordnet sein. Das Befestigungsmittel kann beispielsweise durch eine Schnappverbindung und/oder einen mechanischen Verriegelungsmechanismus gebildet werden.

Der Wechselrichter 1 wird bevorzugt in vertikaler Ausrichtung an einer Wand befestigt, wobei das Drehelement 35 im Wesentlichen horizontal im oberen Bereich des Wechselrichters 1 angeordnet ist. Bei einem derart vertikal montierten Wechselrichter 1 liegt also das Drehelement 35 bei eingehängtem oberen Gehäuseteil 33 an der Kulissenbahn 36 an. Damit wird erreicht, dass bei einer Lösung des Befestigungsmittels der obere Gehäuseteil 33 nicht vom unteren Gehäuseteil 34 fallen kann, da dieser über das Drehelement 35 und die Kulissenbahn 36 zusammengehalten wird.

Wie bei einem üblichen Aufbau eines Wechselrichters 1 erforderlich, kann der obere Gehäuseteil 33 vom unteren Gehäuseteil 34 abgenommen werden. Der obere Gehäuseteil 33 wird nicht wie beim Stand der Technik einfach gerade, also horizontal, vom unteren Gehäuseteil 34 abgezogen, sondern der obere Gehäuseteil 33 muss aufgrund des in der Kulissenbahn 36 gelagerten Drehelements 35 zuerst, wie in Fig. 3 dargestellt, gegenüber dem unteren Gehäuseteil 34, in Richtung des Pfeils 57, mit einer Schwenkbewegung gedreht oder abgehoben werden. Dadurch werden die einzelnen Vorsprünge bzw. Wandelemente der Gehäuseteile 33, 34 voneinander getrennt, bis die beiden Gehäuseteile 33, 34 nur mehr über das Drehelement 35 und die Kulissenbahn 36 gehalten werden. Nunmehr kann der obere Gehäuseteil 33 gegenüber dem unteren Gehäuseteil 34 über die Länge 37 nach oben geschoben werden, bis das Drehelement 35 im Bereich der Öffnung 39 in der Kulissenbahn 36 positioniert ist. Daraufhin kann der obere Gehäuseteil 33 im Wesentlichen in einer horizontalen Bewegung vom unteren Gehäuseteil 34 weggezogen werden, wobei das Drehelement 35 durch die Öffnung 39 geführt wird.

Das Befestigen oder Aufsetzen des oberen Gehäuseteils 33 auf den unteren Gehäuseteil 34 erfolgt in umgekehrter Reihenfolge. Zuerst wird der obere Gehäuseteil 33 leicht schräg zum unteren Gehäuseteil 34 über dem unteren Gehäuseteil 34 positioniert, sodass die Öffnung 39 der Kulissenbahn 36 und das Drehelement 35 übereinander liegen. Damit kann nun der obere Gehäuseteil 33 auf den unteren Gehäuseteil 34 aufgesteckt werden, sodass das Drehelement 35 über die Öffnung 39 in die Kulissenbahn 36 eingeschoben wird. Durch eine vertikale Verschiebung wird das Drehelement 35 derart positioniert, dass nunmehr der obere Gehäuseteil 33 über eine Schwenkbewegung auf den unteren Gehäuseteil 34 aufgesetzt wird.

Der Ordnung halber wird darauf hingewiesen, dass die Kulissenbahn 36 auch am unteren Gehäuseteil 34 und korrespondierend das Drehelement 35 am oberen Gehäuseteil 33 angeordnet sein kann. Damit bei einer derartigen Ausbildung ein Herabfallen des oberen Gehäuseteils 33 beim Verschwenken verhindert wird, ist die Kulissenbahn 36 derart ausgebildet, dass zum Abnehmen der obere Gehäuseteil 34 wiederum angehoben werden muss und anschließend erst weggezogen werden kann. Selbstverständlich kann auch eine Ausbildung geschaffen werden, bei der das Drehelement 35 und die Kulissenbahn 36 im unteren Bereich der Gehäuseteile 33, 34 angeordnet werden und somit zum Abnehmen der obere Bereich verschwenkt werden muss. Dabei ist wiederum darauf zu achten, dass die Kulissenbahn 36 entsprechend ausgebildet wird, sodass beim Verschwenken des oberen Gehäuseteils 33 dieser nicht herunterfallen kann. Die Trennung der beiden Gehäuseteile 33, 34 soll immer derart erfolgen, dass zuerst eine Drehbewegung (Schwenken) und anschließend eine Linearbewegung (Abheben) durchgeführt wird.

Da bei den modernen Wechselrichtern 1 üblicherweise Einstellmöglichkeiten und Anzeigeelemente angeordnet sind, sind meist im oberen und unteren Gehäuseteil 33, 34 elektronische Komponenten angeordnet. Beim Verbinden der beiden Gehäuseteile 33, 34 soll eine automatische Kontaktierung zwischen den elektronischen Komponenten des oberen und unteren Gehäuseteils 33, 34 stattfinden. Bei automatischen Kontaktierungssystemen 40 des Standes der Technik wird immer eine lineare Bewegung der beiden Gehäuseteile 33, 34 zueinander ausgeführt.

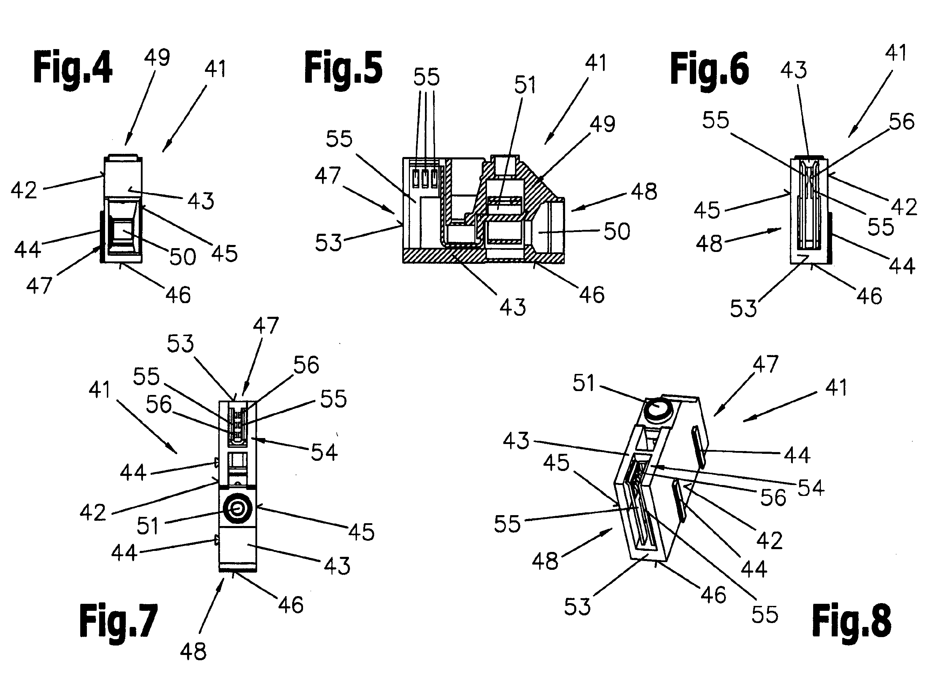

Beim erfindungsgemäßen Wechselrichter 1 findet die automatische Kontaktierung während einer Drehbewegung der Gehäuseteile 33, 34 um die Drehachse des Drehelements 35 statt. Hierzu ist ein entsprechendes Kontaktierungssystem 40 im Wechselrichter 1 angeordnet, welches im Detail in den Fig. 4 bis 8 dargestellt ist.

Bei der in den Fig. 4 bis 8 dargestellten Ausführungsform handelst es sich um ein Einzelelement 41 des Kontaktierungssystems 40. Das Einzelelement 41 kann zu einem beliebigen Klemmblock zusammengesetzt werden, wozu auf einer Seitenwand 42 eines elektrisch isoliert ausgebildeten Gehäuses 43 zumindest ein, bevorzugt jedoch zwei Führungsvorsprünge 44 und korrespondierend auf einer gegenüberliegenden Seitenwand 45 Führungsnuten angeordnet sind (nicht dargestellt). Auf diese Weise können mehrere Einzelelemente 41, wie bereits aus dem Stand der Technik bekannt, zusammengesteckt werden. Der Ordnung halber wird jedoch darauf hingewiesen, dass das Kontaktierungssystem 40 auch aus einem größeren Block, also einteilig, gebildet werden kann.

Es können auch unterschiedliche Ausbildungen der Einzelelemente 41, insbesondere der Gehäuse 43, miteinander kombiniert werden. Beispielsweise können auf einigen Einzelelementen 41 auf der Auflagefläche 46 Erhebungen (nicht dargestellt) zum Befestigen an einer Leiterplatte angeordnet sein, die mit den dargestellten Einzelelementen 41 in gewissen Abständen kombiniert werden, sodass der daraus gebildete Block einfach auf einer Leiterplatte befestigt werden kann.

Beim Kontaktierungssystem 40, insbesondere beim Einzelelement 41, handelt es sich um eine Art Klemmblock, bei dem in einem Gehäuse 43 auf einer Seite ein Kontaktelement 47 angeordnet ist und auf einer anderen Seite ein Anschlusselement 48 für eine Leitung oder Kabel vorhanden ist. Das Kontaktelement 47 und das Anschlusselement 48 sind elektrisch miteinander verbunden.

Das Anschlusselement 48 wird beispielsweise mit einer Klemmvorrichtung 49 zum Befestigen eines Kabels, welches über eine Öffnung 50 im Gehäuse 43 des Kontaktierungssystems 40 eingeführt werden kann, und anschließend über ein Befestigungsmittel 51 bevorzugt in Form einer Schraubklemme fixiert. Da eine derartige Ausbildung bereits aus dem Stand der Technik hinlänglich bekannt ist, wird auf den mechanischen Aufbau nicht näher eingegangen.

Das Kontaktelement 47 ist zur Aufnahme einer korrespondierend ausgebildeten Kontaktfahne 52 ausgebildet. Die Kontaktfahne 52 kann über eine Schwenkbewegung bzw. Drehbewegung in das Kontaktelement 47 gesteckt werden. Dazu ist das Kontaktelement 47 auf der dem Anschlusselement 48 gegenüberliegenden Seite, also der Stirnseite 53 des Gehäuses 43, offen oder frei zugänglich ausgebildet, sodass die Kontaktfahne 52 in einer kreisbogenförmigen Bahn in das Kontaktelement 47 eingeführt werden kann. Das Kontaktelement 47 ist zumindest durch einen, insbesondere zwei Federkontakt(e) 55 gebildet. Dabei ist im Gehäuse 43 eine bevorzugt rechteckförmige Ausnehmung 54, insbesondere ein Schlitz, angeordnet, in welcher der zumindest eine Federkontakt 55 angeordnet ist. Die Federkontakte 55 sind so weit voneinander distanziert, dass die Kontaktfahne 52 dazwischen eingeführt werden kann. Die Federkontakte 55 sind stehend, also in einem Winkel von insbesondere 90° zur Auflagefläche 46, im Gehäuse 43 angeordnet, sodass die Kontaktfahne 52 von oben in einer kreisförmigen Bahn in die Ausnehmung 54 einsteckbar ist. Im dargestellten Ausführungsbeispiel ist in einem Winkel von ca. 90° zum Anschlusselement 48 eine Öffnung 50 insbesondere zur Aufnahme des Kabels angeordnet. Somit kann von oben und über die offene Stirnfläche 53 die Kontaktfahne 52 in einer kreisbogenförmigen Bahn eingeführt werden. Um eine sichere Kontaktierung zu erreichen, sind die Federkontakte 55 bevorzugt mit federnd vorspringenden Erhebungen 56 ausgebildet, die beim Einführen der Kontaktfahne 55 verformt und/oder in entsprechende Ausnehmungen gepresst werden.

Das in den Fig. 4 bis 8 beschriebene Kontaktierungssystem 40 ist beim Wechselrichter 1 der Fig. 2 und 3 integriert. Hierzu sind am oberen Gehäuseteil 33 die Kontaktfahnen 52 angeordnet. Die Kontaktfahnen 52 sind dabei bevorzugt auf einer Leiterplatte befestigt oder mit einem entsprechenden Teil einer Klemme mit Anschlussklemmen für Leitungen verbunden und ragen in Richtung unterer Gehäuseteil 34. Im unteren Gehäuseteil 34 des Wechselrichters 1 sind zu den Kontaktfahnen 52 korrespondierende Einzelelemente 41 des Kontaktierungssystems 40 zu einem gemeinsamen Klemmblock zusammengesetzt und entsprechend befestigt.

Es wird somit ein Wechselrichter 1 mit einem oberen und unteren Gehäuseteil 33, 34, geschaffen, bei dem im oberen und unteren Gehäuseteil 33, 34 elektronische Komponenten angeordnet sind, die über ein aus zwei Teilen gebildetes Kontaktierungssystem 40 miteinander elektrisch verbunden sind. Der obere Gehäuseteil 33 ist über ein Drehelement 35 mit dem unteren Gehäuseteil 34 manuell abnehmbar verbunden, wobei das Drehelement 35 eine Drehachse für einen Kreisbogen 58, wie schematisch mit strichlierten Linien angedeutet, bildet. Im oberen und unteren Gehäuseteil 33, 34 ist jeweils ein Teil des Kontaktierungssystems 40 derart entlang dieses Kreisbogens 58 angeordnet, dass diese Teile des Kontaktierungssystems 40 während einer Schwenkbewegung des oberen Gehäuseteils 33 gegenüber dem unteren Gehäuseteil 34 in eine Betriebsstellung, bei verbundenen Gehäuseteilen 33, 34, automatisch kontaktiert werden. Selbstverständlich ist es auch möglich, dass nicht nur Gehäuseteile 33, 34 über das Drehelement 35 und das Kontaktierungssystem 40 miteinander verbunden werden, sondern dass eigenständige Geräte derart miteinander gekoppelt werden, dass über das Kontaktierungssystem 40 Daten und/oder Signale ausgetauscht werden und auch eine Energieübertragung stattfinden kann. Die Gehäuseteile 33, 34 können also durch Geräte ersetzt werden, deren Gehäuse derart ausgebildet sind, dass diese entsprechend miteinander gekoppelt werden können. Auch können mehrere, beispielsweise drei übereinander angeordnete Gehäuseteile oder Geräte mit einem derartigen System verbunden werden.

Grundsätzlich können die Kontaktfahnen 52 in einem Gehäuse mit einem elektrisch leitend verbundenen Anschlusselement 48, wie dies für die Federelemente 55 beschrieben wurde, angeordnet sein. Beim Kontaktierungssystem 40 ist in einem Gehäuseteil 33, 34 oder einem Gerät zumindest ein Einzelelement 41 mit den Federkontakten 55 und korrespondierend dazu im weiteren Gehäuseteil 33, 34 oder Gerät zumindest eine Kontaktfahne 52 angeordnet. In den beiden mechanischen Komponenten können entsprechende Anschlusselemente 48, beispielsweise in Form von Stecker-Buchsenleisten für Leistungs- und Signalübertragung montiert und entsprechend verkabelt werden.

Eine derartige Ausbildung kann auch in anderen Bereichen, insbesondere in der Schweißtechnik oder für Batterieladegeräte, eingesetzt werden. Hierzu kann beispielsweise ein Frontpanel eines Schweißgeräts oder Batterieladegeräts, an dem die verschiedensten Bedienelemente, Einstellelemente und Anzeigeelemente angeordnet sind, schwenkbar über ein Drehelement mit dem Gehäuse des Schweißgeräts oder Batterieladegeräts verbunden sein, wie dies zuvor beschrieben wurde. Darüber hinaus kann ein derartiger Aufbau natürlich auch bei einem Inselwechselrichter eingesetzt werden.

## Patentansprüche

1. Wechselrichter (1), mit einem oberen und unteren Gehäuseteil (33, 34), wobei im oberen und unteren Gehäuseteil (33, 34) elektronische Komponenten angeordnet sind, die über ein aus zwei Teilen gebildetes Kontaktierungssystem (40) lösbar miteinander elektrisch verbunden sind, **dadurch gekennzeichnet, dass** der obere Gehäuseteil (33) über ein Drehelement (35) mit dem unteren Gehäuseteil (34) manuell abnehmbar verbunden ist, wobei das Drehelement (35) eine Drehachse für einen Kreisbogen (58) bildet, und dass im oberen und unteren Gehäuseteil (33, 34) jeweils ein Teil des Kontaktierungssystems (40) derart entlang des Kreisbogens (58) angeordnet ist, dass diese während einer Schwenkbewegung des oberen Gehäuseteils (33) gegenüber dem unteren Gehäuseteil (34) in eine Betriebsstellung bei verbundenen Gehäuseteilen (33, 34) automatisch kontaktierbar sind.

2. Wechselrichter (1) nach Anspruch 1, **dadurch gekennzeichnet, dass** der obere Gehäuseteil (33) eine Kulissenbahn (36) aufweist.

3. Wechselrichter (1) nach Anspruch 2, **dadurch gekennzeichnet, dass** die Kulissenbahn (36) über eine definierte Länge (37) in einem Durchmesser (38) des Drehelements (35) in Längsrichtung des Gehäuseteils (33) verläuft, worauf sich die Kulissenbahn (36) winkelig nach außen erstreckt und somit eine Öffnung (39) zur Aufnahme des Drehelements (35) ausgebildet ist.

4. Wechselrichter (1) nach einem der Ansprüche 1 bis 3, **dadurch gekennzeichnet, dass** in einem Gehäuseteil (33, 34) oder einem Gerät zumindest ein Einzelelement (41) und korrespondierend dazu im weiteren Gehäuseteil (33, 34) oder Gerät zumindest eine Kontaktfahne (52) des Kontaktierungssystems (40) angeordnet ist.

5. Wechselrichter (1) nach Anspruch 4, **dadurch gekennzeichnet, dass** an einer Seite eines Gehäuses (43) des Einzelelements (41) des Kontaktierungssystems (40) ein Kontaktelement (47) und an einer anderen Seite des Gehäuses (43) ein Anschlusselement (48) für eine Leitung oder Kabel angeordnet ist, und das Kontaktelement (47) und das Anschlusselement (48) miteinander verbunden sind.

6. Wechselrichter (1) nach Anspruch 5, **dadurch gekennzeichnet, dass** das Kontaktelement (47) an einer dem Anschlusselement (48) gegenüberliegenden Stirnseite (53) des Gehäuses (43) offen ausgebildet ist.

7. Wechselrichter (1) nach Anspruch 5 oder 6, **dadurch gekennzeichnet, dass** das Kontaktelement (47) durch zumindest einen, insbesondere zwei Federkontakt(e) (55) gebildet ist, wobei im Gehäuse (43) eine bevorzugt rechteckförmige Ausnehmung (54) zur Anordnung des zumindest einen Federkontakts (55) angeordnet ist.

8. Wechselrichter (1) nach Anspruch 7, **dadurch gekennzeichnet, dass** die Federkontakte (55) stehend, also in einem Winkel von im Wesentlichen 90° zu einer Auflagefläche (46) im Gehäuse (43) angeordnet sind, sodass die Kontaktfahne (52) von oben in einer kreisförmigen Bahn in das Kontaktelement (47) einsteckbar ist.

## Claims

1. An inverter (1) comprising an upper and a lower housing part (33, 34), wherein electronic components are arranged in the upper and lower housing parts (33, 34), which are electronically connected to one another in a releasable manner by means of a contact-making system (40) formed from two parts, **characterised in that** the upper housing part (33) is connected to the lower housing part (34) in a manually detachable manner by means of a rotating element (35), wherein the rotating element (35) forms an axis of rotation for a circle arc (58), and **in that** in the upper and lower housing parts (33, 34), parts of the contact-making system (40) are arranged, respectively, along this circle arc (58) in such a way that these parts, during a pivoting movement of the upper housing part (33) relative to the lower housing part (34) into an operating position, can be automatically contact-connected, with the housing parts (33, 34) connected.

2. The inverter (1) according to claim 1, **characterised in that** the upper housing part (33) comprises a slotted guide track (36).

3. The inverter (1) according to claim 2, **characterised in that** the slotted guide track (36) extends in a diameter (38) of the rotating element (35) in the longitudinal direction of the housing part (33) for a defined length (37), whereupon the slotted guide track (36) extends to the outside in an angular manner, thus forming an opening (39) for receiving the rotating element (35) .

4. The inverter (1) according to any one of claims 1 to 3, **characterised in that** at least one single element (41) is arranged in a housing part (33, 34) or device, and at least one corresponding contact tab (52) of the contact-making system (40) is arranged in the other housing part (33, 34) or device.

5. The inverter (1) according to claim 4, **characterised in that** a contact element (47) is arranged on one side of a housing (43) of the single element (41) of the contact-making system (40), and a connecting element (48) for a line or a cable is arranged on another side of the housing (43), and the contact element (47) and the connecting element (48) are connected to one another.

6. The inverter (1) according to claim 5, **characterised in that** the contact element (47) is designed in an open manner on a front face (53) of the housing (43) opposite the connecting element (48) .

7. The inverter (1) according to claim 5 or 6, **characterised in that** the contact element (47) is formed by at least one, in particular two, spring contact(s) (55), wherein a preferably rectangular recess (54) for arrangement of the at least one spring contact (55) is arranged in the housing (43).

8. The inverter (1) according to claim 7, **characterised in that** the spring contacts (55) are arranged standing, i. e. in an angle of substantially 90° to a supporting surface (46) within the housing (43), so the contact tab (52) may be inserted into the contact element (47) from above in a circular trajectory.

## Revendications

1. Onduleur (1), comprenant une partie de boîtier supérieure et une partie de boîtier inférieure (33, 34), sachant que sont disposés, dans les parties de boîtier supérieure et inférieure (33, 34), des composants électroniques, qui sont raccordés électriquement les uns aux autres de manière amovible par l'intermédiaire d'un système de mise en contact (40) formé de deux parties, **caractérisé en ce que** la partie de boîtier supérieure (33) est raccordée de manière à pouvoir être retirée manuellement à la partie de boîtier inférieure (34) par l'intermédiaire d'un élément rotatif (35), l'élément rotatif (35) formant un axe de rotation pour un arc de cercle (58), et **en ce que** respectivement une partie du système de mise en contact (40) est disposée dans les parties de boîtier supérieure et inférieure (33, 34) de telle manière le long de l'arc de cercle (58) que lesdites parties peuvent être mises en contact automatiquement, au cours d'un déplacement par pivotement de la partie de boîtier supérieure (33) par rapport à la partie de boîtier inférieure (34), dans une position de fonctionnement avec les parties de boîtier (33, 34) raccordées.

2. Onduleur (1) selon la revendication 1, **caractérisé en ce que** la partie de boîtier supérieure (33) présente une glissière (36).

3. Onduleur (1) selon la revendication 2, **caractérisé en ce que** la glissière (36) s'étend dans la direction longitudinale de la partie de boîtier (33) sur une longueur (37) définie dans un diamètre (38) de l'élément rotatif (35), la glissière (36) s'étendant vers l'extérieur selon un angle de manière à former ce faisant une ouverture (39) servant à recevoir l'élément rotatif (35).

4. Onduleur (1) selon l'une quelconque des revendications 1 à 3, **caractérisé en ce qu'**au moins un élément individuel (41) est disposé dans une partie de boîtier (33, 34) ou dans un appareil, et **en ce que** de manière correspondante au moins une longuette de contact (52) du système de mise en contact (40) est disposée dans l'autre partie de boîtier (33, 34) ou dans l'appareil.

5. Onduleur (1) selon la revendication 4, **caractérisé en ce qu'**un élément de contact (47) est disposé au niveau d'un côté d'un boîtier (43) de l'élément individuel (41) du système de mise en contact (40), et **en ce qu'**un élément de connexion (48) destiné à une ligne ou à un câble est disposé au niveau de l'autre côté du boîtier (43), l'élément de contact (47) et l'élément de connexion (48) étant reliés entre eux.

6. Onduleur (1) selon la revendication 5, **caractérisé en ce que** l'élément de contact (47) est réalisé de manière ouverte au niveau d'un côté frontal (53), faisant face à l'élément de connexion (48), du boîtier (43).

7. Onduleur (1) selon la revendication 5 ou 6, **caractérisé en ce que** l'élément de contact (47) est formé par au moins un, en particulier deux, contacts élastiques (55), sachant qu'un évidement (54) de préférence rectangulaire servant à accueillir le au moins un contact élastique (55) est disposé dans le boîtier (43).

8. Onduleur (1) selon la revendication 7, **caractérisé en ce que** les contacts élastiques (55) sont disposés dans le boîtier (43) à la verticale, en d'autres termes selon un angle de sensiblement 90° par rapport à une surface d'appui (46), de sorte que la languette de contact (52) peut être insérée dans l'élément de contact (47) depuis le haut dans une voie circulaire.
